Europäisches Patentamt

European Patent Office

Office européen des brevets

(19)

(11) EP 1 500 982 A1

(12) EUROPEAN PATENT APPLICATION

(43) Date of publication:
26.01.2005 Bulletin 2005/04

(51) Int Cl.⁷: G03F 7/20

(21) Application number: 03255228.3

(22) Date of filing: 24.07.2003

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(71) Applicant: ASML Netherlands B.V.
5504 DR Veldhoven (NL)

(72) Inventor: The designation of the inventor has not
yet been filed

(74) Representative: Leeming, John Gerard
J.A. Kemp & Co.,
14 South Square,
Gray's Inn
London WC1R 5JJ (GB)

Remarks:
Claims 11 and 12 are deemed to be abandoned due
to non-payment of the claims fees (Rule 31 (2) EPC).

(54) **Lithographic apparatus and device manufacturing method**

(57) In a lithographic projection apparatus a liquid supply system maintains liquid in a space between a final element of the projection system and the substrate of the lithographic projection apparatus. A sensor positioned on a substrate table which holds the substrate is adapted for being imaged when immersed in immersion liquid (i.e. under the same conditions as the substrate will be imaged). By ensuring that a primary outer surface of an absorption element of the sensor is formed of one or fewer metal types, long life of the sensor can be expected.

Fig. 5

**Description**

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for at least partly filling a space between the final element of said projection system and said substrate with an immersion liquid.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

It has been proposed to immerse the substrate in the lithographic projection apparatus in an immersion liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system and also increasing the depth of focus.)

However, submersing the substrate or substrate and substrate table in a bath of liquid (see for example US 4,509,852, hereby incorporated in its entirety by reference) means that there is a large body of liquid that must be accelerated during a scanning exposure.

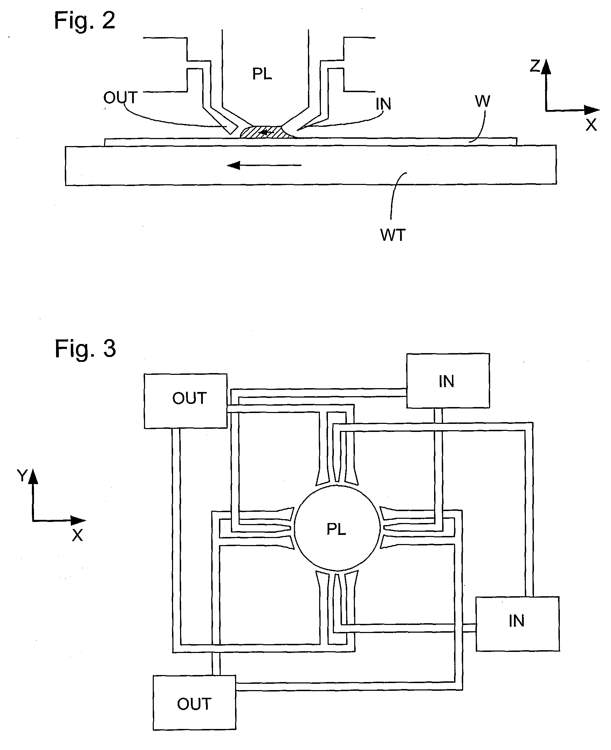

Another of the solutions proposed is for a liquid supply system to provide liquid on only a localized area of the substrate and in between the final element of the projection system and the substrate (the substrate generally has a larger surface area than the final element of the projection system). One way which has been proposed to arrange for this is disclosed in WO 99/49504, hereby incorporated in its entirety by reference. As illustrated in Figures 2 and 3, liquid is supplied by at least one inlet IN onto the substrate, preferably along the direction of movement of the substrate relative to the final element, and is removed by at least one outlet OUT after having passed under the projection system. That is, as the substrate is scanned beneath the element in a -X direction, liquid is supplied at the +X side of the element and taken up at the -X side. Figure 2 shows the arrangement schematically in which liquid is supplied via inlet IN and is taken up on the other side of the element by outlet OUT which is connected to a low pressure source. In the illustration of Figure 2 the liquid is supplied along the direction of movement of the substrate relative to the final element, though this does not need to be the case. Various orientations and numbers of in- and out-lets positioned around the final element are possible, one example is illustrated in Figure 3 in which four sets of an inlet with an outlet on either side are provided in a regular pattern around the final element.

Another solution which has been proposed is to provide the liquid supply system with a seal member which extends along at least a part of a boundary of the space between the final element of the projection system and the substrate table. The seal member is substantially stationary relative to the projection system in the XY plane though there may be some relative movement in the Z direction (in the direction of the optical axis). A seal is formed between the seal member and the surface of the substrate. Preferably the seal is a contactless seal such as a gas seal. Such a solution is disclosed in European Patent Application number 03252955.4 hereby incorporated in its entirety by reference.

A conventional lithographic projection apparatus requires several sensors on the substrate table so that the substrate table which carries the substrate can be correctly positioned relative to the projection beam. These sensors include a Transmission Image Sensor (TIS) which is a sensor that is used the measure the position at wafer level of a projected aerial image of a mark pattern at the reticle level (mask). Typically the projected image at wafer level is a line pattern with a line width similar to projection beam wavelength. The TIS measures these mask patterns by using a transmission pattern with a photo cell underneath. The sensor data is used to measure the position of the mask wrt the position of the wafer table in six degrees of freedom. Also the magnification and scalling of the projected mask are measured, since four points on the mask are used for the measurement. As the sensor must also be capable of measuring the pattern positions and influences of all illumination settings (Sigma, Lens NA, all masks (Binary, PSM,...)) a small line width is required. Furthermore the sensor is also used to measure/monitor the optical performance of the apparatus. Different measurements are implemented for measuring Pupil shapes, Coma, Spherical, Astigmatism and Field curvature. For these measurements, different illumination settings are used in combination with different projected images. Also such a sensor may be an Integrated Lens Interferometer At Scanner (ILIAS) which is an interferometric wavefront measurement system implemented on lithography tools. ILIAS performs (static) measurements on lens aberrations (up to Zernicke 36) as are needed for system setup and qualification. ILIAS is an on scanner integrated measurement system used for system setup and calibration. ILIAS is used for monitoring and recalibration of the scanner on a regular basis depending on the machine needs. Also such a sensor may be a dose (spot sensor). All of these sensors are used at substrate level and as such are positioned on the substrate table. In order to avoid the need to perform complex predications about how the immersion liquid will effect the projection beam, it is desirable to illuminate the sensors under the same conditions as the substrate is to be imaged i.e. with immersion liquid in place between the final element of the projection system and the sensor.

Sensors of the type mentioned above used in conventional lithographic projection apparatus require the presence of an absorption layer positioned over a grating in front of the actual photo sensor element detector. The absorbing layer is required to ensure that the sensor is a high contrast sensor so that accurate readings can be made. The absorbing layer has open and closed areas to get a high signal contrast between the light transmitted through the open patterns on the plate and the closed absorbing area. The photo sensor below the absorbing layer is normally much larger than the open patterns in order to measure the light for large angles. The ratio of the open pattern area versus the photo sensitive area in a typical sensor is roughly (1:5600). So it is critical to absorb as much light as possible using an absorbing layer on the closed areas above the photo sensor. Area patterns with a line width of the order of 200 nm are required. To implement this a multi-layer structure is used so that the required resolution can easily be achieved. Typically the absorption elements of such sensors are made of a plurality of layers of different metal types. Chromium is the most widely used because it is common on mask production, and has good absorbing properties for blocking UV and DUV light. Aluminum is also used because it has good etch selectivity wrt chromium and a good optical density. Other metals, both elemental and alloys, may be suitable. Metals are preferred because of their good electrical conductivity and optical reflectivity which is useful for substrate table height measurements.

In a prior art immersion lithographic projection apparatus disclosed in US 5,825,043 sensors are arranged above the substrate table relying on reflection of radiation off the surface of the substrate table thereby avoiding the need to make the sensors resistant to immersion liquid. This results in a loss in accuracy.

It is an object of the present invention to provide accurate sensors for use in an immersion lithographic projection apparatus.

This and other objects are achieved according to the invention in a lithographic apparatus as specified in the opening paragraph, characterized by a sensor mounted on said substrate table for being exposed by radiation whilst immersed in immersion liquid from said liquid supply system, said sensor including an outer surface in contact with said immersion liquid during irradiation of said sensor being formed of one or fewer metal types.

In this way the formation of a galvanic cell between two dissimilar metal types when immersed in immersion liquid can be prevented. This allows the sensor to be positioned on the substrate table. Because of the required small size of the features on the absorption element, if a galvanic cell is allowed to be established, the effectiveness of that absorption element will quickly decrease as one of the metal types dissolves away. Thus, a high contrast sensor is achieved by the invention which provides a long service lifetime in the immersion environment.

The term metal type means an elemental metal or an alloy.

In one embodiment the outer surface is formed by a continuous layer of one metal type. One way of then providing the areas of different absorption characteristics is by providing the one layer so that it is not uniform in thickness. Thus, the use of two metals in the absorption element is completely avoided so that even with minor damage to the continuous layer a galvanic cell will not be established.

Alternatively the absorption element may comprise at least one layer of an isolation material. This isolation material provides a convenient way to ensure that different metal types can be electrically insulated from one another or isolated liquid from the immersion. Preferably the layer is continuous but need not be as long as two metal types are insulated from one another or isolated from the immersion liquid. In one embodiment the absorption element comprises at least one layer of metal and which is not uniform in thickness. In that embodiment the outer surface may comprise areas of said layer of isolation material and areas of one of said at least one layer of one metal type. If the at least one layer of metal is two layers of metal each of a different metal type then the layer of isolation material may be an electrical insulation material and be sandwiched between the two layers each of a different metal type.

Also when the absorption element comprises at least one layer of an isolation material, the absorption element may comprise two layers each of a different one metal type so that the advantages of using layers of two different metals are available for ease of manufacture of the areas of 200 nm line width. Those two layers each of a different one metal type may be in contact if the layer of isolation material forms the outer surface. This is advantageous because the manufacturer of the absorption element is significantly simplified if the two layers each of a different metal type are deposited one on the other.

According to a further aspect of the invention there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,

characterized by illuminating a sensor on said substrate table after providing an immersion liquid between said final element and said sensor; wherein said sensor includes an outer surface in contact with said immersion liquid being formed of one or fewer metal types.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm).

Embodiments of the invention will now be described, by way of example only, with reference to the accompanying schematic drawings in which:

Figure 1 depicts a lithographic projection apparatus according to an embodiment of the invention;
Figure 2 illustrates a liquid supply system according to an embodiment of the invention;
Figure 3 illustrates, in plan, the system of Figure 3;
Figure 4 illustrates another liquid supply system as well as a sensor according to the present invention;
Figure 5 illustrates a sensor according to the first embodiment of the present invention;
Figure 6 illustrates a sensor according to a second embodiment of the present invention;
Figure 7 illustrates a sensor according to a third embodiment of the present invention; and
Figure 8 illustrates a sensor according to a fourth embodiment of the invention.

In the Figures, corresponding reference symbols indicate corresponding parts.

Embodiment 1

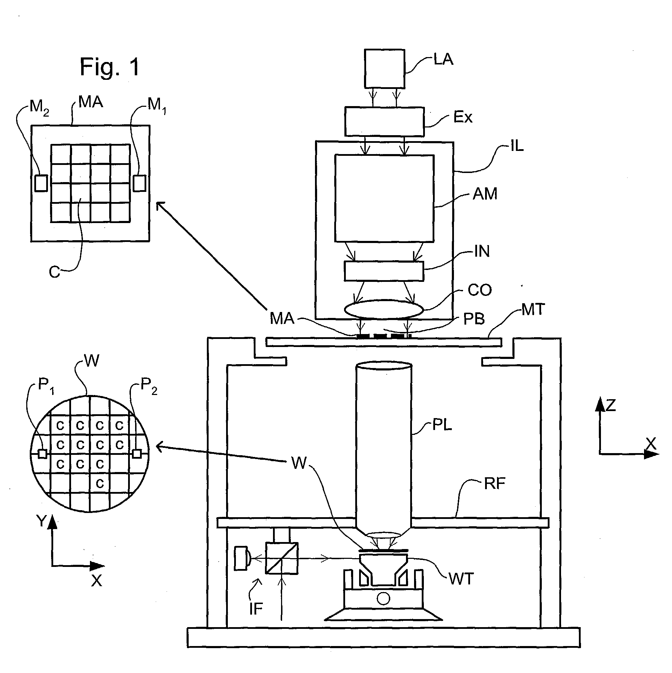

Figure 1 schematically depicts a lithographic projection apparatus according to a particular embodiment of the invention. The apparatus comprises:

· a radiation system Ex, IL, for supplying a projection beam PB of radiation (*e.g.* DUV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a refractive system) for imaging an irradiated portion of the mask MA onto a target portion C (*e.g.* comprising one or more dies) of the substrate W.

As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed $v$, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or $1/5$). In this manner, a relatively large target portion C can be exposed, without having to compromise on resolution.

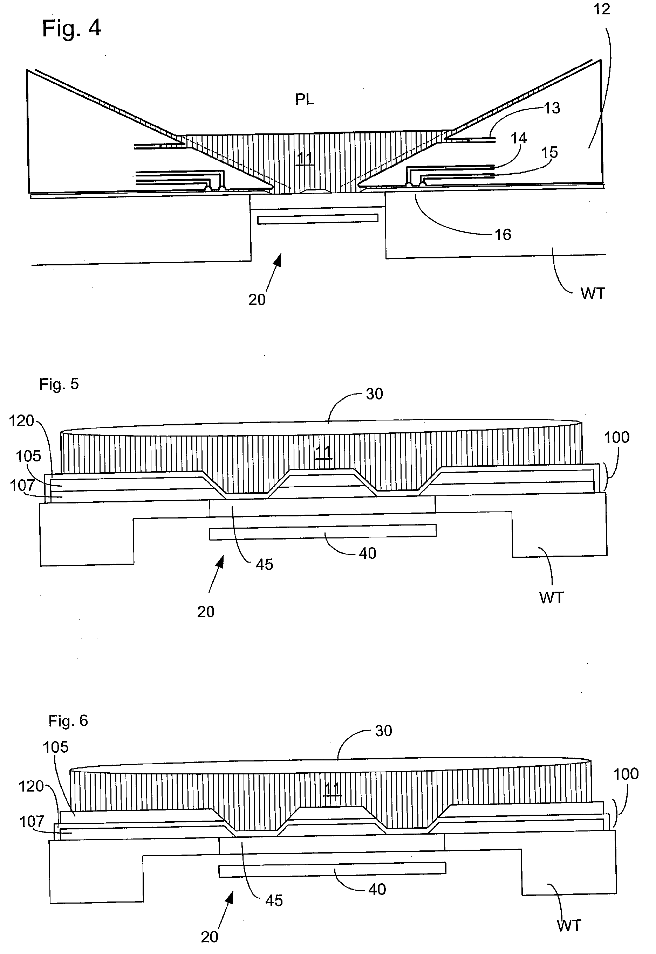

Figure 4 shows a liquid reservoir 10 between the projection system PL and a sensor 20 which is positioned on the substrate stage WT. The liquid reservoir 10 is filled with a liquid 11 having a relatively high refractive index, e. g. water, provided via inlet/outlet ducts 13. The liquid has the effect that the radiation of the projection beam is a shorter wavelength in the liquid than in air or in a vacuum, allowing smaller features to be resolved. It is well known that the resolution limit of a projection system is determined, *inter alia*, by the wavelength of the projection beam and the numerical aperture of the system. The presence of the liquid may also be regarded as increasing the effective numerical aperture. Furthermore, at fixed numerical aperture, the liquid is effective to increase the depth of field.

The reservoir 10 forms a preferably contactless seal to the substrate W around the image field of the projection lens PL so that the liquid is confined to fill the space between the substrate's primary surface, which faces the projection system PL, and the final optical element of the projection system PL. The reservoir is formed by a seal member 12 positioned below and surrounding the final element of the projection lens PL. Thus, the liquid supply system provides liquid on only a localized area of the substrate. The seal member 12 forms part of the liquid supply system for filling the space between the final element of the projection system and the sensor 10 (or substrate W) with a liquid. This liquid is brought into the space below the projection lens and within the seal member 12. The seal member 12 extends a little above the bottom element of the projection lens and the liquid rises above the final element so that a buffer of liquid is provided. The seal member 12 has an inner periphery that at the upper end closely conforms to the shape of the projection system or the final elements thereof and may, e.g. be round. At the bottom the inner periphery forms an aperture which closely conforms to the shape of the image field, e.g. rectangular, though this is not necessarily so. The projection beam passes through this aperture.

The liquid 11 is confined in the reservoir 10 by a seal device 16. As illustrated in Figure 2, the seal device is a contactless seal, i.e. a gas seal. The gas seal is formed by gas, e.g. air or synthetic air, provided under pressure via inlet 15 to the gap between seal member 12 and substrate W and extracted by first outlet 14. The over pressure on the gas inlet 15, vacuum level on the first outlet 14 and the geometry of the gap are arranged so that there is a high-velocity air flow inwards towards the optical axis of the apparatus that confines the liquid 11. As with any seal, some liquid is likely to escape, for example up the first outlet 14.

Figures 2 and 3 also depict a liquid reservoir defined by inlet(s) IN, outlet(s) OUT, the substrate W and the final element of projection lens PL. Like the liquid supply system of Figure 4 the liquid supply system illustrated in Figures 2 and 3, comprising inlet(s) IN and outlet(s) OUT, supplies liquid to a space between the final element of the projection system and a localized area of the primary surface of the substrate.

Both of the liquid supply systems of Figures 2 & 3 and Figure 4 can be used with the sensor 20 which is illustrated in more detail in Figure 5. In Figure 5 the liquid supply system is not illustrated but the final element of the projection system 30 is depicted as is the liquid reservoir 10, filled with immersion liquid 11.

The sensor 20 is comprised of a sensor element detector 40, a transmissive sensor grating 45 and an absorption element 100. The absorption element 100 is used to enhance the sensor contrast and thus the overall sensor performance. The contrast in this sensor due to the absorption element 100 is the ratio of the light transmitted through an open area of the pattern in relation to the amount of light that is transmitted through the closed area i.e. the areas which are covered. The behaviour of the absorbing element is mainly driven by the ratio of the open area of the transmissive sensor grating 45 and the area of the absorbing element 100 above the sensor element detector 40. For the TIS, the ratio of the open grating area vs closed absorbing area is 1:5600. In order to obtain a 0.1 % contribution of the light transmitted through the absorption element 100 an optical density of 10e-3/5600~2e-7 is required.

The transmissive sensor grating 45 is used for convolution of the projected aerial image of a corresponding pattern at reticle level (4 or 5 times larger than the pattern on the sensor). The convolution of the transmissive sensor grating 45 with the projected aerial image of the pattern at reticle level will provide an intensity profile depending on the position of the transmission sensor grating 45 at substrate level. With the intensity data at different substrate table positions the position and shape of the aerial image can be calculated.

The sensor element detector 40 transforms the light that is transmitted through the open area of the grating into an electrical signal. However, the total amount of light that is transmitted through he grating 45 and the absorption element 100 contribute to the total electrical signal. In order to get a good sensor performance the amount of light that transmits through the absorption element 100 must be minimized (less than 0.1% of the light transmitted through the open area). If the optical density of the absorption layer 100 is to large, the sensor performance will degrade.

The purpose of the absorption element 100 is thus to absorb part of the energy of the projection beam PB so that the sensor can achieve sufficient contrast by providing areas of different absorption characteristics. The absorption element 100 is preferably made of at least one metal layer such as aluminium and/or chromium (or alloys thereof) but may be made of layers of any metals. Al and Cr are particularly efficient at absorbing projection beam radiation.

The total thickness of the metal layers is of the order of a 200 nm. In an Al/Cr multi-layer, the Al layer is typically 100 nm and the Cr layer 90 nm thick. The width of the areas not covered is of the order of 100 to 300 nm for TIS and 2-5 μm for ILIAS. The problem with using two layers each of different metal types in the absorption element is that a galvanic cell may be set up when the two metal types are in electrical contact and in contact with an electrolyte i.e. the immersion liquid. In such a galvanic cell the less noble metal (aluminium) reacts as in reaction 1:

$$Al \rightarrow Al^{3+} + 3e^- \qquad\qquad \text{(reaction 1)}$$

The three electrons generated in reaction 1 move to the chromium-immersion liquid interface where reaction 2 takes place. In the case of an immersion liquid based on water, the reaction is:

$$2H_2O + O_2 + 4e^- \rightarrow 4OH^- \qquad\qquad \text{(reaction 2)}$$

For immersion liquids other than water, a slightly different reaction takes place.
When these reactions are summed the following reaction takes place:

$$4Al + 6H_2O + 3O_2 \rightarrow 4Al^{3+} + 12OH^- \qquad\qquad \text{(reaction 3)}$$

As a rule of thumb, the rate of the overall reaction is influenced, among others, by the metals involved. The closer their positions in the galvanic series, the lower the corrosion rate will be. Metals close to aluminum in the galvanic series, such as zinc or cadmium, have drawbacks that make them not suitable for use in this application to replace the chromium.

In the first embodiment the establishment of such a galvanic cell is prevented by the use of a continuous layer 120 of an isolation material such as $SiO_2$ or SiN typically between 20 and 100 nm in thickness. The isolation material may either be liquid impermeable (either electrically insulative or conductive) or an electrical insulator and must be transparent to the radiation with which the sensor is irradiated. An electrical insulator is preferred. The continuous layer 120 covers both metal layers 105, 107 of the absorption element 100 (i.e. an outer surface of the absorption element 100 which is in contact with the immersion liquid during exposure of the sensor is formed by the continuous layer) such that a galvanic reaction between the two metal layers or even between two different metal types in a single layer cannot proceed because the second metal layer 107 (the chromium layer) is isolated from the immersion liquid 11 so that reaction 2 cannot proceed.

As will be appreciated, each of the two metal layers 105, 107 may be made of different types of metal and indeed this embodiment can also be used with only a single layer of metal which may be made of one or more types of metal.

Embodiment 2

The second embodiment will now be described with reference to Figure 6 and is the same as the first embodiment except as described below.

In the second embodiment the absorption layer 100 also consists of two metal layers 105, 107. However, in the second embodiment the continuous isolation layer 120 is made of an electrical insulation material and is sandwiched between the first and second layers 105, 107. Thus, the surface of the absorption element 100 is formed partly of the first metal layer 105 and partly of the layer of insulation material 120. In this embodiment the function of the layer of insulation material 120 is to electrically isolate the first and second metal layers 105, 107 from each other such that no galvanic couple exists. In this embodiment the first metal layer 105 must be made of a single metal type i.e. an elemental metal or an alloy but not of two elemental metals or two alloys which are not fully alloyed. The second metal layer 107 may be made of one or more metal types.

Embodiment 3

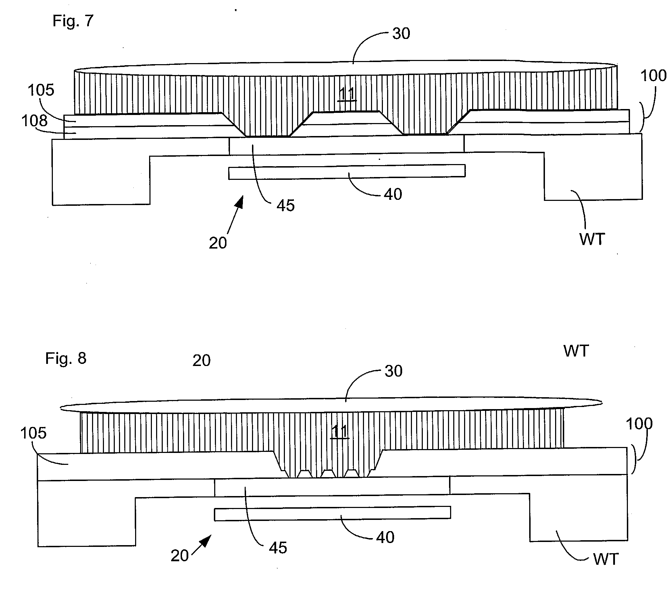

The third embodiment will now be described with reference to Figure 7 and is the same as the first embodiment save as described below.

In the third embodiment, there is no layer of insulation material 120. There are two layers 105, 108, one of which is a metal layer 105, preferably of Cr and another of which is a non-metal layer 108, such as a ceramic, for example a metal carbide or nitride, preferably TiN. The layers 105,108 may be either way around. This combination also has good resistance to galvanic corrosion and has the advantage of being easy to manufacture as each layer needs only to be about 100 nm thick.

Embodiment 4

The fourth embodiment will now be described with reference to Figure 8 and is the same as the first embodiment except as described below.

In the third embodiment the formation of a galvanic couple is prevented by the use of only one metal type in the absorption element 100. The single metal type may be deposited in a layer 105. The areas of different absorption characteristics are formed by depositing the metal layer 105 in different thicknesses so that the thickness of the layer 105 is not uniform. As only one metal type is exposed to the immersion liquid, no galvanic couple exists.

In all of the above described embodiments, the metal layers 105, 107 may be of various thicknesses over the area of the sensor. The variation thicknesses include areas where the layer is not deposited at all (as in Figures 5, 6 and 7). The first and second embodiments have been described with the metal layers either in existence in a given area at a certain thickness, or not existent in a area at all, this need not be the case and the thicknesses of the layers may vary over the area of the sensor.

Preferably the transmissive sensor grating 45 and the substrate table WT are made of non conductive materials. This is advantageous as a galvanic couple cannot then be set up between the metal layers 105, 107 deposited on the substrate table WT or transmissive sensor grating 45 and other metals which are also in contact with the immersion liquid.

The above described methods of avoiding the formation of galvanic cells can be applied to any parts of sensors which are immersed in immersion liquid.

Whilst specific embodiments of the invention have been described above, it will be appreciated that the invention may be practiced otherwise than as described. The description is not intended to limit the invention.

**Claims**

**1.** A lithographic projection apparatus comprising:

- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for at least partly filling a space between the final element of said projection system and said substrate with an immersion liquid;

**characterized by** a sensor mounted on said substrate table for being exposed by radiation whilst immersed in immersion liquid from said liquid supply system, said sensor including an outer surface in contact with said immersion liquid during irradiation of said sensor being formed of one or fewer metal types.

2. A lithographic projection apparatus according to claim 1, wherein said outer surface is formed by a continuous layer of one metal type.

3. A lithographic projection apparatus according to claim 2, wherein said continuous layer is not uniform in thickness, thereby to provide areas with different absorption characteristics.

4. A lithographic projection apparatus according to claim 1, wherein said outer surface is formed of a layer of one metal type and said sensor comprises a further layer of a ceramic material.

5. A lithographic projection apparatus according to claim 1, wherein said sensor comprises at least one layer of an isolation material.

6. A lithographic projection apparatus according to claim 5, wherein said sensor comprises at least one layer of metal and which is not of uniform thickness.

7. A lithographic projection apparatus according to claim 6, wherein said at least one layer of metal is two layers of metal each of a different metal type.

8. A lithographic projection apparatus according to claims 6 or 7, wherein said primary outer surface comprises areas of said layer of isolation material and areas of one of said at least one layer of metal which is of one metal type.

9. A lithographic projection apparatus according to claim 7, wherein said two layers of metal are in contact and said layer of isolation material is an electrical insulation material and forms said primary outer surface.

10. A lithographic projection apparatus according to claims 7 or 8, wherein said layer of isolation material is sandwiched between said two layers of metal.

11. A lithographic projection apparatus according to any one of the preceding claims, wherein said sensor further comprises an absorption element with areas of different absorption characteristics and said outer surface if formed by said absorption element.

12. A device manufacturing method comprising the steps of:

- providing on a substrate table a substrate that is at least partially covered by a layer of radiation-sensitive material;
- providing a projection beam of radiation using a radiation system;
- using patterning means to endow the projection beam with a pattern in its cross-section;
- providing an immersion liquid at least partly filling a space between the final element of a projection system used in said step of projecting and said substrate;
- projecting the patterned beam of radiation onto a target portion of the layer of radiation-sensitive material;

**characterized by**

- illuminating a sensor on said substrate table after providing an immersion liquid between said final element and said sensor; wherein said sensor includes an outer surface in contact with said immersion liquid being formed of one or fewer metal types.

Fig. 1

**Fig. 2**

**Fig. 3**

Fig. 4

Fig. 5

Fig. 6

Fig. 7

30

105

108

11

100

45

40

20

WT

Fig. 8

20

30

WT

105

11

100

45

40

20

WT

**European Patent Office**

## EUROPEAN SEARCH REPORT

Application Number

EP 03 25 5228

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A,D | EP 0 834 773 A (NIPPON KOGAKU KK) 8 April 1998 (1998-04-08) * column 27, line 43 - column 30, line 5 * ----- | 1-10 | G03F7/20 |

TECHNICAL FIELDS SEARCHED (Int.Cl.7)

G03F

The present search report has been drawn up for all claims

| Place of search | Date of completion of the search | Examiner |
|---|---|---|
| Munich | 1 July 2004 | van Toledo, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 03 25 5228

This annex lists the patent family members relating to the patent documents cited in the above-mentioned European search report.
The members are as contained in the European Patent Office EDP file on
The European Patent Office is in no way liable for these particulars which are merely given for the purpose of information.

01-07-2004

| Patent document cited in search report | | Publication date | Patent family member(s) | | Publication date |
|---|---|---|---|---|---|
| EP 0834773 | A | 08-04-1998 | US | 5825043 A | 20-10-1998 |
| | | | EP | 0834773 A2 | 08-04-1998 |
| | | | JP | 10154659 A | 09-06-1998 |
| | | | US | 6191429 B1 | 20-02-2001 |

EPO FORM P0459

For more details about this annex : see Official Journal of the European Patent Office, No. 12/82